# EUROPEAN PATENT APPLICATION

(11) **EP 3 937 235 A1**
(43) Date of publication of application: **12.01.2022**
(21) Application number: 19919330.1
(22) Date of filing: 21.11.2019
(51) Int. Cl.: H01L 25/04

(54) **SEMICONDUCTOR MODULE AND SEMICONDUCTOR DEVICE**

(30) Priority: 08.03.2019 JP 2019042559
(71) Applicant: AISIN CORPORATION, Aichi 448-8650 (JP)
(72) Inventor: NARUSE, Takanobu, Kariya, Aichi 448-8650 (JP)
(74) Representative: TBK
(86) International application number: PCT/JP2019/045554
(87) International publication number: WO 2020/183802

(57) **Abstract**

Provided is a technique that enables a passive component to be arranged with a short wiring distance to a power terminal of a semiconductor element mounted on a semiconductor module. In a semiconductor module (1), a plurality of first connection terminal groups (81) having connection terminals (8) arranged with a first gap (G1) therebetween, and a second connection terminal group (82) having connection terminals (8) arranged with a second gap (G2) therebetween in a rectangular ring so as to surround the first connection terminal groups, are arranged with a second group gap (G12) therebetween that is wider than the first gap (G1) and the second gap (G2). In a plan view, a first power terminal (26) of a first semiconductor element (2) overlaps a target terminal group (81A) that is one of the first connection terminal groups (81). The connection terminal (8) that belongs to the target terminal group (81A) and that supplies electric power to the first semiconductor element (2) is connected to the first power terminal (26). In the plan view, a second power terminal (36) of a second semiconductor element (3) overlaps the second connection terminal group (82). The connection terminal (8) that belongs to the second connection terminal group (82) and that supplies electric power to the second semiconductor element (3) is connected to the second power terminal (36).

## Description

### TECHNICAL FIELD

The present invention relates to a semiconductor module configured to be mounted on a main substrate such that a surface thereof provided with a plurality of connection terminals faces the main substrate, and relates to a semiconductor device configured by mounting the semiconductor module on a main substrate.

### BACKGROUND ART

A semiconductor module in which a plurality of processors called a system LSI such as a system on a chip (SoC) and a system in a package (SiP) are mounted on a module substrate, and a semiconductor module in which such processors and peripheral elements such as memories are mounted together on a module substrate, are in practical use and called multi-chip modules. As illustrated by example in International Application Publication No. WO 2017/038905, processors such as an SoC and an SiP are generally provided with connection terminals that are of a type called a ball grid array (BGA). A synchronous dynamic random access memory (SDRAM) is often used for a memory that works in conjunction with a processor, and an SDRAM having a large capacity is provided with BGA-type connection terminals. A multi-chip module provided with such processors and memories generally have connection terminals that are BGA-type connection terminals.

As disclosed in International Application Publication cited above, semiconductor elements such as processors and memories are mounted on one side of a module substrate of a multi-chip module, and connection terminals are formed on the other side. A multi-chip module is mounted such that a surface thereof where connection terminals are formed faces a substrate or the like of a product (hereinafter referred to as a main substrate). Among connection terminals of semiconductor elements such as processors and memories, connection terminals that are configured to be connected to a main substrate are connected to connection terminals of a multi-chip module via through holes formed in a module substrate and are connected to the main substrate via the connection terminals of the multi-chip module.

### Related Art Documents

### Patent Documents

Patent Document 1: International Application Publication No. WO 2017/038905

### SUMMARY OF THE INVENTION

### Problem to be Solved by the Invention

In semiconductor elements having BGA-type connection terminals, power terminals are often arranged dispersedly at a plurality of locations in order to supply electric power evenly to internal cells of a package. Further, it is common for passive components such as bypass capacitors to be arranged in the vicinities of power terminals of a semiconductor element in order to reduce noise. However, in the case of a BGA type having connection terminals that spread in a planar fashion, when bypass capacitors are arranged in directions along a substrate surface of a module substrate relative to a semiconductor element, the wiring distance may increase, so that noise reduction effect may be limited. Thus, with focus on directions orthogonal to the substrate surface, for example, it is conceivable to arrange bypass capacitors on a main substrate where a multi-chip module is mounted. That is, it is conceivable to arrange bypass capacitors on one surface of the main substrate that is opposite the other surface (a mounting surface) thereof where the multi-chip module is mounted. However, when connections terminal of a multi-chip module are of a BGA type, to draw wires from the connections terminal, through holes are often formed in a main substrate at locations that correspond to the connections terminal of the multi-chip module in a view orthogonal to a substrate surface. As a result, openings of the through holes are formed on a surface opposite a mounting surface. For this reason, in many cases, it is difficult to provide room for arrangement of bypass capacitors on the surface opposite the mounting surface of the main substrate.

In view of the above background, there is a need to provide a technique that enables a passive component to be arranged with a short wiring distance to a power terminal of a semiconductor element mounted on a semiconductor module.

### Means for Solving the Problem

In view of the above, a semiconductor module according to an aspect is a semiconductor module in which a first semiconductor element and a second semiconductor element are mounted on a first surface of a rectangular module substrate and in which a plurality of connection terminals are provided on a second surface opposite the first surface. The semiconductor module is configured to be mounted on a main substrate such that the second surface faces the main substrate. The plurality of connection terminals provided on the second surface include a plurality of connection terminal groups that are arranged regularly. The plurality of connection terminal groups include a plurality of first connection terminal groups in which adjacent ones of the connection terminals are arranged with a first gap therebetween in a grid, and also includes a second connection terminal group in which adjacent ones of the connection terminals are arranged with a second gap therebetween in a rectangular ring so as to surround the plurality of first connection terminal groups. The connection terminals that are adjacent to each other between different ones of the first connection terminal groups are arranged with a first group gap therebetween that is greater than or equal to the first gap and the second gap. The connection terminals that are adjacent to each other between each of the plurality of first connection terminal groups and the second connection terminal group are arranged with a second group gap therebetween that is wider than the first gap and the second gap. In a plan view that is a view in a direction orthogonal to the module substrate, a first power terminal that is a power terminal of the first semiconductor element overlaps a target terminal group that is one of the plurality of first connection terminal groups. The connection terminal that belongs to the target terminal group and that supplies electric power to the first semiconductor element is connected to the first power terminal. In the plan view, a second power terminal that is a power terminal of the second semiconductor element overlaps the second connection terminal group. The connection terminal that belongs to the second connection terminal group and that supplies electric power to the second semiconductor element is connected to the second power terminal.

This structure enables the connection terminal that belongs to the target terminal group and that supplies electric power to the first semiconductor element to be connected to the first power terminal with a short wiring distance along a direction orthogonal to the module substrate. This structure also enables the connection terminal that belongs to the second connection terminal group and that supplies electric power to the second semiconductor element to be connected to the second power terminal with a short wiring distance along the direction orthogonal to the module substrate. It is noted here that a clearance of the second group gap is provided between the target terminal group (the first connection terminal group) and the second connection terminal group. Thus, as described below, by using this clearance, it is possible to mount components on the main substrate at locations close to the first power terminal and the second power terminal. For example, in some cases, through holes may be formed in the main substrate between a mounting surface on which the semiconductor module is mounted and a surface opposite the mounting surface, in order to electrically connect the opposite surface to the connection terminals. As a result, openings of the through holes may be formed on the opposite surface according to the arrangement of the connection terminals. It is impossible to mount components on the surface opposite the mounting surface at locations that overlap such openings in the plan view. However, since no connection terminals are located in a region corresponding to the clearance of the second group gap, such openings are not formed therein. Thus, it is possible to mount components in the region corresponding to the clearance of the second group gap in the plan view, on the surface of the main substrate opposite the mounting surface. That is, this structure enables passive components to be arranged with a short wiring distance to power terminals of a semiconductor element mounted on a semiconductor module.

It is preferable here that the first semiconductor element be a processor and that the second semiconductor element be a memory. In other words, the semiconductor module is a semiconductor module in which a processor and a memory are mounted on a first surface of a rectangular module substrate and in which a plurality of connection terminals are provided on a second surface opposite the first surface. The semiconductor module is configured to be mounted on a main substrate such that the second surface faces the main substrate. The plurality of connection terminals provided on the second surface include a plurality of connection terminal groups that are arranged regularly. The plurality of connection terminal groups include a plurality of first connection terminal groups in which adjacent ones of the connection terminals are arranged with a first gap therebetween in a grid, and a second connection terminal group in which adjacent ones of the connection terminals are arranged with a second gap therebetween in a rectangular ring so as to surround the plurality of first connection terminal groups. The connection terminals that are adjacent to each other between different ones of the first connection terminal groups are arranged with a first group gap therebetween that is greater than or equal to the first gap and the second gap. The connection terminals that are adjacent to each other between each of the first connection terminal groups and the second connection terminal group are arranged with a second group gap therebetween that is wider than the first gap and the second gap. In a plan view that is a view in a direction orthogonal to the module substrate, first power terminals that are power terminals of the processor overlap a target terminal group that is one of the plurality of first connection terminal groups. The connection terminals that belong to the target terminal group and that supply electric power to the processor are connected to the first power terminals. In the plan view, second power terminals that are power terminals of the memory overlap the second connection terminal group. The connection terminals that belong to the second connection terminal group and that supply electric power to the memory are connected to the second power terminals.

A processor and a memory often work in conjunction with each other, and there are many signal wires that are connected only between the processor and the memory. This often allows a semiconductor module provided with a processor and a memory to be provided with fewer connection terminals than the total number of connection terminals of the processor and connection terminals of the memory. Thus, mounting the semiconductor module on the main substrate improves wiring efficiency and mounting efficiency, compared to when mounting the processor and the memory on the main substrate. In many cases, a processor consumes a large amount of current and is provided with many power terminals. A die that structures a processor is located in the center of a package. Therefore, when connection terminals of the processor are of a BGA, the power terminals are often located in the central area. Further, in memories, which grow in capacity, power terminals are often arranged dispersedly in order to supply electric power evenly to internal memory cells of the memory. When passive components are connected to power terminals of a processor and power terminals of a memory, the wiring distance may increase, so that the effect of the passive components may be limited. However, as described above, this structure enables passive components to be mounted in the region corresponding to the clearance of the second group gap in the plan view, on the surface of the main substrate opposite the mounting surface. Thus, it is possible to connect passive components to the power terminals of the processor and the power terminals of the memory with a short wiring distance along a direction orthogonal to the module substrate and the main substrate.

Other features and advantages of the semiconductor module and the semiconductor device having the semiconductor module mounted thereon will be better understood by referring to the following description of embodiments in conjunction with the drawings.

### BRIEF DESCRIPTION OF THE DRAWINGS

[FIG. 1] FIG. 1 is a schematic perspective exploded view of a semiconductor device.
[FIG. 2] FIG. 2 is a diagram illustrating the arrangement of components of a semiconductor module.
[FIG. 3] FIG. 3 is a transparent plan view illustrating one example of connection terminals of the semiconductor module.
[FIG. 4] FIG. 4 is a transparent plan view illustrating one example of connection terminals of an SDRAM
[FIG. 5] FIG. 5 is a transparent plan view illustrating one example of connection terminals of a system LSI.
[FIG. 6] FIG. 6 is a transparent plan view illustrating one example of a relationship between connection terminal groups of the semiconductor module and connection terminals of a semiconductor element.
[FIG. 7] FIG. 7 is a schematic cross-sectional view of the semiconductor device.
[FIG. 8] FIG. 8 is a circuit block diagram illustrating one example of a relationship between the SDRAM and a bypass capacitor.
[FIG. 9] FIG. 9 is a circuit block diagram illustrating one example of a relationship between the SDRAM and a LC filter.
[FIG. 10] FIG. 10 is a transparent plan view illustrating another example of the connection terminals of the semiconductor module.
[FIG. 11] FIG. 11 is a transparent plan view illustrating another example of the connection terminals of the semiconductor module.
[FIG. 12] FIG. 12 is a transparent plan view illustrating another example of the connection terminals of the semiconductor module.

### MODES FOR CARRYING OUT THE INVENTION

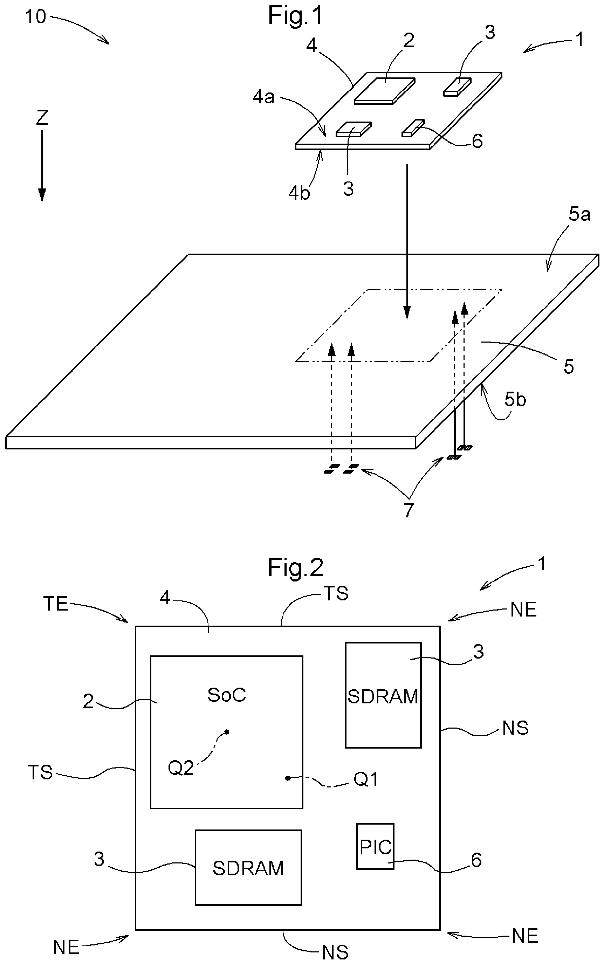

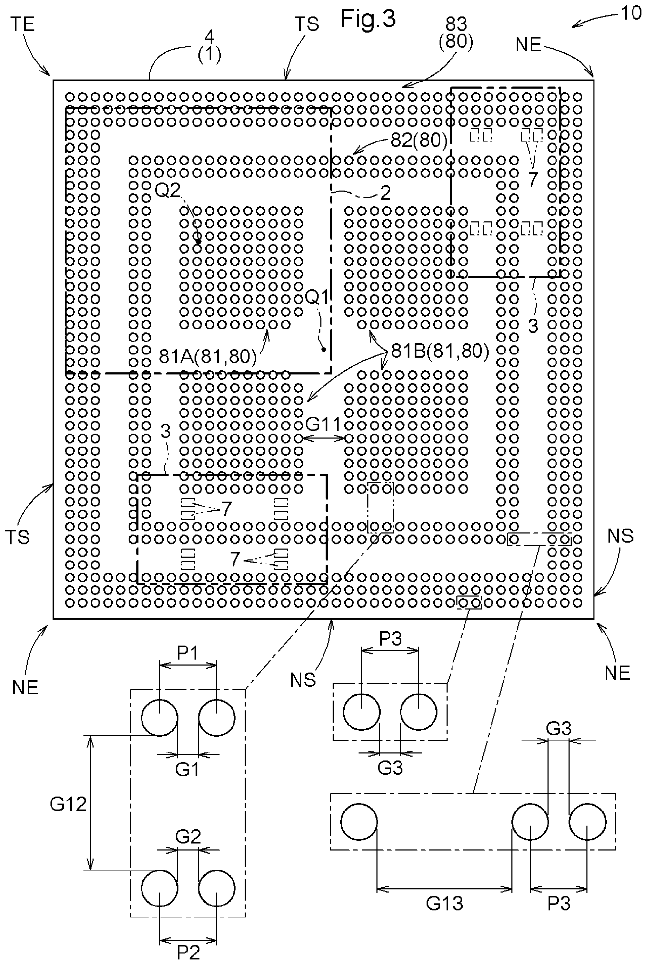

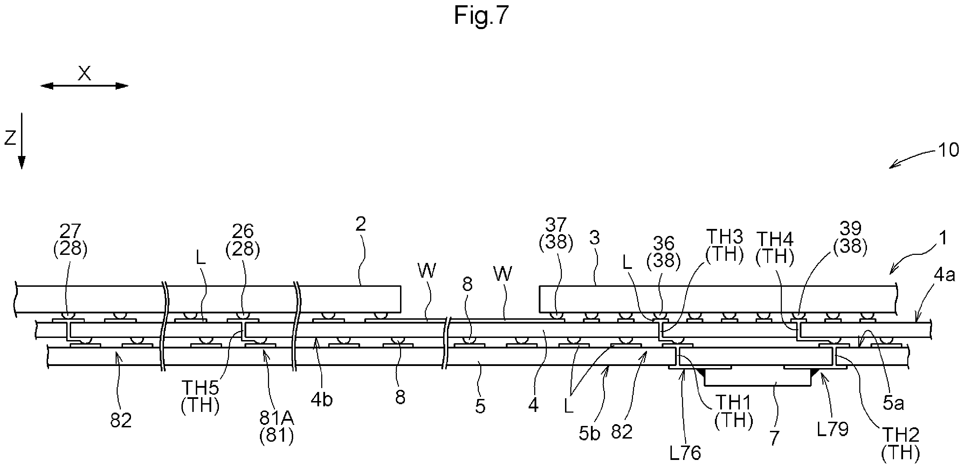

Below, embodiments of a semiconductor module and a semiconductor device are described based on the drawings. As illustrated in the schematic perspective exploded view of FIG. 1, a semiconductor device 10 is structured to include a semiconductor module 1 and a main substrate 5. At least the semiconductor module 1 is mounted on a first surface (a main-substrate first surface 5a) of the main substrate 5. In the semiconductor module 1, a system LSI 2 (a processor, a first semiconductor element) and a memory 3 (a second semiconductor element) are mounted on a first surface (a module-substrate first surface 4a) of a rectangular module substrate 4), and a plurality of connection terminals 8 (refer to FIG. 3 and FIG. 7, among others) are provided on a module-substrate second surface 4b that is opposite the module-substrate first surface 4a. The semiconductor module 1 is mounted on the main substrate 5 such that the module-substrate second surface 4b faces the main-substrate first surface 5a of the main substrate 5.

The memory 3 works in conjunction with the system LSI 2. According to the present embodiment, the semiconductor module 1 is further provided with a portion of a power supply circuit (a power supply IC 6 that is described later) for supplying electric power to the memory 3. As illustrated in the component arrangement diagram of FIG. 2, at least the following are mounted on the module substrate 4: a system on a chip (SoC) as the system LSI 2; two synchronous dynamic random access memories (SDRAMs) as the memory 3; and a power supply IC 6 (PIC: Power IC) as the portion of the power supply circuit. The outside shape of the system LSI 2 (a first semiconductor element) is greater than the outside shape of the memory 3 (a second semiconductor element), and the system LSI 2 is greater in area in a plan view than the memory 3. According to the present embodiment, the outside shape of the system LSI 2 (a first semiconductor element) is square, and the outside shape of the memory 3 (a second semiconductor element) is rectangular.

As described above, a SoC is used herein as an example of the system LSI 2. Alternatively, the system LSI 2 may be a system in a package (SiP). The SoC includes an application specific integrated circuit (ASIC) that is a semi-custom LSI, an application specific standard processor (ASSP) that is a general-purpose LSI, and the like. The ASIC includes not only a gate array or a cell-based IC (a standard cell), but also a programmable logic device (PLD) such as a field programmable gate array (FPGA) and a programmable logic array (PLA).

Preferably, the SDRAM may be, for example, a double data rate 3 (DDR3) SDRAM, a double data rate 4 (DDR4) SDRAM, or the like. Although the SDRAM is used herein as an example of the memory 3, this does not eliminate the possibility that the memory 3 may be a memory with other structure, such as a flash memory or a static RAM (SRAM). As described above, the memory 3 works in conjunction with the system LSI 2. For this purpose, signal terminals of the memory 3 (address terminals, data terminals, control terminals, among others) are connected to only the system LSI 2 on the module substrate 4. According to the present embodiment, electric power used to drive the memory 3 is generated by the power supply circuit that is built around the power supply IC 6 mounted on the module substrate 4. Further, electric power used to drive others, such as an input-output section (terminal input-output pads) that is connected to the memory 3 in the system LSI 2, may be also supplied from the power supply IC 6.

As described above, the connection terminals 8 that are configured to be connected to the main substrate 5 are arranged regularly on the module-substrate second surface 4b of the semiconductor module 1 (a facing surface that faces the main-substrate first surface 5a). According to the present embodiment, a ball grid array (BGA) type having the regularly-arranged connection terminals 8 that are hemispherical in shape is used as an example of the semiconductor module 1. FIG. 3 illustrates a transparent plan view of the module-substrate second surface 4b of the semiconductor module 1 mounted on the main substrate 5. The plan view of FIG. 3 is a view (a Z-direction view) when the semiconductor module 1 is viewed from the module-substrate first surface 4a side in a direction Z orthogonal to the module substrate 4. In FIG. 3, the plurality of connection terminals 8 arranged on the module-substrate second surface 4b are illustrated by continuous lines, and the outside shapes of the system LSI 2 and two memories included in components mounted on the module-substrate first surface 4a are illustrated by hidden lines. Likewise, the outside shapes of bypass capacitors 7 (details are described later) that are included in components mounted on a main-substrate second surface 5b opposite the main-substrate first surface 5a and that are passive components connected to power terminals of the memories 3 are illustrated by hidden lines.

As illustrated in FIG. 3, the plurality of connection terminals 8 provided on the module-substrate second surface 4b include a plurality of connection terminal groups 80 that are arranged regularly. According to the present embodiment, the plurality of connection terminal groups 80 include a plurality of first connection terminal groups 81, one second connection terminal group 82, and one third connection terminal group 83. Four first connection terminal groups 81 are arranged to surround a center of gravity Q1 of the outside shape of the module substrate 4 in the Z-direction view. In each of the first connection terminal groups 81, adjacent connection terminals 8 are arranged with a first gap G1 therebetween in a grid. When the thickness of the connection terminals 8 is not considered, it can be said that adjacent connection terminals 8 in each of the first terminal groups are arranged with a first pitch P1 (at a first repeating interval) in a grid. In the second connection terminal group 82, adjacent connection terminals 8 are arranged with a second gap G2 therebetween in a rectangular ring so as to surround the plurality of first connection terminal groups 81. Likewise, it can be said that adjacent connection terminals 8 in the second connection terminal group 82 are arranged with a second pitch P2 (at a second repeating interval) in a rectangular ring so as to surround the plurality of first connection terminal groups 81. In the third connection terminal group 83, adjacent connection terminals 8 are arranged with a third gap G3 therebetween in a rectangular ring so as to surround the second connection terminal group 82. Likewise, it can be said that adjacent connection terminals 8 in the third connection terminal group 83 are arranged with a third pitch P3 (at a third repeating interval) in a rectangular ring so as to surround the second connection terminal group 82.

The connection terminals 8 that are adj acent to each other between different ones of the first connection terminal groups 81 are arranged with a first group gap G11 therebetween that is wider than the first gap G1 and the second gap G2. That is, the plurality of first connection terminal groups 81 are arranged to have the first group gaps G11 therebetween in directions that are along a substrate surface of the module substrate 4 and that are orthogonal to sides of the module substrate 4 that is rectangular in shape. Further, the connection terminals 8 that are adjacent to each other between the first connection terminal group 81 and the second connection terminal group 82 are arranged with a second group gap G12 therebetween that is wider than the first gap G1 and the second gap G2. That is, the first connection terminal group 81 and the second connection terminal group 82 are arranged to have the second group gap G12 therebetween in directions that are along the substrate surface of the module substrate 4 and that are orthogonal to the sides of the module substrate 4 that is rectangular in shape. Furthermore, the connection terminals 8 that are adjacent to each other between the second connection terminal group 82 and the third connection terminal group 83 are arranged with a third group gap G13 therebetween that is wider than the first gap G1, the second gap G2, and the third gap G3. That is, the second connection terminal group 82 and the third connection terminal group 83 are arranged to have the third group gap G13 therebetween in directions that are along the substrate surface of the module substrate 4 and that are orthogonal to the sides of the module substrate 4 that is rectangular in shape.

It is noted here that the first gap G1 (the first pitch PI), the second gap G2 (the second pitch P2), the third gap G3 (the third pitch P3) may have the same value as each other or have different values from each other. According to the present embodiment, since the first pitch P1, the second pitch P2, and the third pitch P3 are equal to each other, and all the connection terminals 8 have the same thickness as each other, the first gap G1, the second gap G2, and the third gap G3 are equal to each other. The first pitch P1 (= P2, = P3) here may be, for example, 1 [mm].

Likewise, the first group gap G11, the second group gap G12, and the third group gap G13 may have the same value as each other or have different values from each other. According to the present embodiment, the second group gap G12 and the third group gap G13 have the same value as each other, and the first group gap G11 is greater than the second group gap G12 and the third group gap G13. The first group gap G11 is set to a value that allows three connection terminals 8 to be arranged at the first pitch P1 (= P2, = P3) between the first connection terminal groups 81. Each of the second group gap G12 and the third group gap G13 is set to a value that allows two connection terminals 8 to be arranged at the first pitch P1 (= P2, = P3) between corresponding adjacent terminal groups. When the first pitch P1 (= P2, = P3) is 1 [mm], the first group gap G11 is set to a value that is equal to or greater than 2 [mm] and less than 4 [mm] (about 3 [mm] when the thickness of the connection terminal 8 is less than 0.5 [mm]). On the other hand, the second group gap G12 and the third group gap G13 are set to values that are equal to or greater than 1 [mm] and less than 3 [mm] (about 2 [mm] when the thickness of the connection terminal 8 is less than 0.5 [mm]).

As illustrated in FIG. 3, the plurality of first connection terminal groups 81 are arranged to have four-fold rotational symmetry with the center of gravity Q1 of the outside shape of the module substrate 4 in the Z-direction view serving as a reference point of rotational symmetry. The second connection terminal group 82 is also arranged to have four-fold rotational symmetry with the center of gravity Q1 serving as a reference point of rotational symmetry. Likewise, the third connection terminal group 83 is arranged to have four-fold rotational symmetry with the center of gravity Q1 serving as a reference point of rotational symmetry. That is, the plurality of connection terminals 8 are all arranged to have four-fold rotational symmetry with the center of gravity Q1 serving as a reference point of rotational symmetry. Thus, when the semiconductor module 1 is mounted on the main substrate 5, stress is almost evenly applied to the connection terminals 8. This provides a strength to resist external force (such as vibration and impact) applied to the semiconductor device 10, thereby increasing the reliability of the semiconductor device 10.

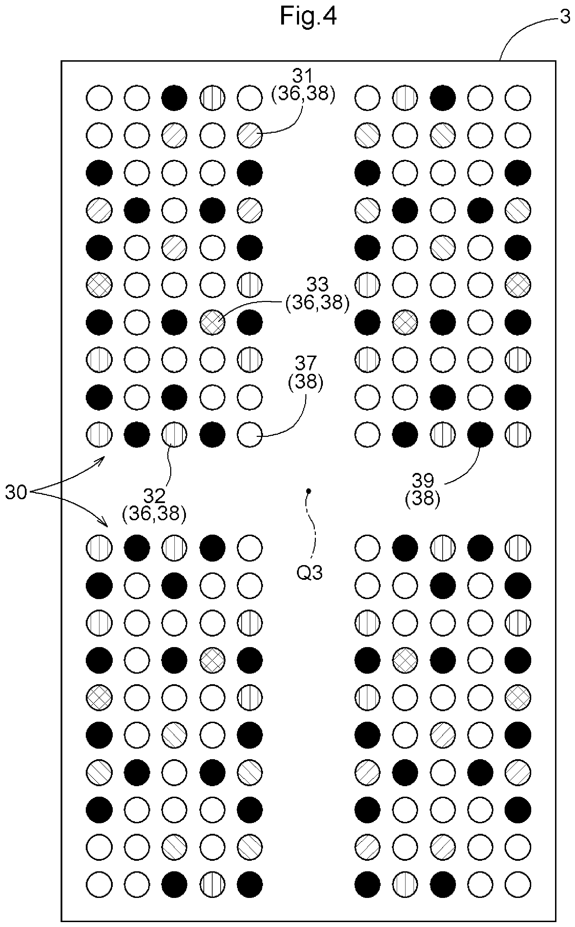

FIG. 4 illustrates the arrangement of connection terminals (memory terminals 38) of the memory 3 with a transparent plan view of a surface of the memory 3 that faces the module-substrate first surface 4a when the memory 3 is mounted on the module substrate 4. The plan view of FIG. 4 is a view (the Z-direction view) from the module-substrate first surface 4a side in the direction Z orthogonal to the module substrate 4. The memory 3 has four memory terminal groups 30 each of which is arranged in a 5 by 10 grid. Like the first connection terminal groups 81 of the semiconductor module 1, the four memory terminal groups 30 are arranged in a 2 by 2 grid and are arranged to have four-fold rotational symmetry with a center of gravity Q3 of the outside shape of the memory 3 serving as a reference point of rotational symmetry. A gap that allows two memory terminals 38 to be arranged therein is provided between all the memory terminal groups 30. A pitch (a repeating interval) between the memory terminals 38 may be, for example, 0.65 [mm].

In FIG. 4, the memory terminals 38 other than those indicated by black outlines are terminals related to power supply, and terminals having different functions are indicated by different hatching patterns. Here is one example where the memory terminals 38 are for DDR4 SDRAM First memory power terminals 31, which are indicated by diagonal hatching, are the memory terminals 38 that are supplied with electric power (For DDR4, a rated voltage of 1.2 [V]) to drive the core of the memory 3. Second memory power terminals 32, which are indicated by vertical hatching, are the memory terminals 38 that are supplied with electric power (For DDR4, a rated voltage of 1.2 [V]) to drive the input-output section of the memory 3. Third memory power terminals 33, which are indicated by crosshatching, are the memory terminals 38 that are supplied with electric power (electric power to provide a word line voltage: For DDR4, a rated voltage of 2.5 [V]) to write data in the memory 3. Memory ground terminals 39, which are indicated by being filled with black color, are the memory terminals 38 that are connected to ground. Memory signal terminals 37, which are indicated by black outlines, are the memory terminals 38 for data signals, address signals, and control signals. The memory signal terminals 37 may include reserved terminals. The three types of terminals described herein as an example of the power terminals of the memory 3 are collectively referred to as memory power terminals 36 (second power terminals).

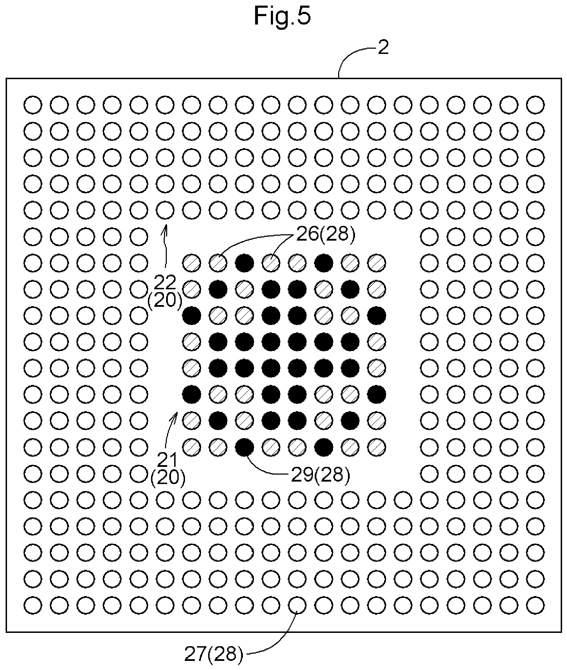

FIG. 5 illustrates the arrangement of connection terminals (processor terminals 28) of the system LSI 2 with a transparent plan view of a surface of the system LSI 2 that faces the module-substrate first surface 4a when the system LSI 2 is mounted on the module substrate 4. The plan view of FIG. 5 is a view (the Z-direction view) from the module-substrate first surface 4a side in the direction Z orthogonal to the module substrate 4. The processor terminals 28 also have a plurality of processor groups 20. The processor terminals 28 have a central terminal group 21 that is arranged in a grid in the central area (in the vicinity of a center of gravity Q2 (see FIG. 2, FIG. 3) of the outside shape of the system LSI 2), and an annular terminal group 22 that is arranged in a rectangular ring so as to surround the central terminal group 21. A pitch (a repeating interval) between the processor terminals 28 may be, for example, 1 [mm].

FIG. 5 illustrates attributes of the processor terminals 28 only in the central terminal group 21. In FIG. 5, the processor terminals 28 that are indicated by diagonal hatching and by black outlines are terminals related to power supply. The processor terminals 28 that are indicated by diagonal hatching are processor power terminals 26 (first power terminals) that are supplied with electric power to drive the system LSI 2. Although the system LSI 2 is often supplied with a plurality of powers in many cases, they are not distinguished here. The processor terminals 28 may be such that the same electric power is input to all the processor power terminals 26, or the processor terminals 28 may have a plurality of types that are supplied with different electric powers. The processor terminals 28 that are indicated by being filled with black color are processor ground terminals 29 that are connected to ground. The annular terminal group 22 includes processor signal terminals 27 used to input and output signals. Naturally, the processor power terminals 26 may be included in the annular terminal group 22.

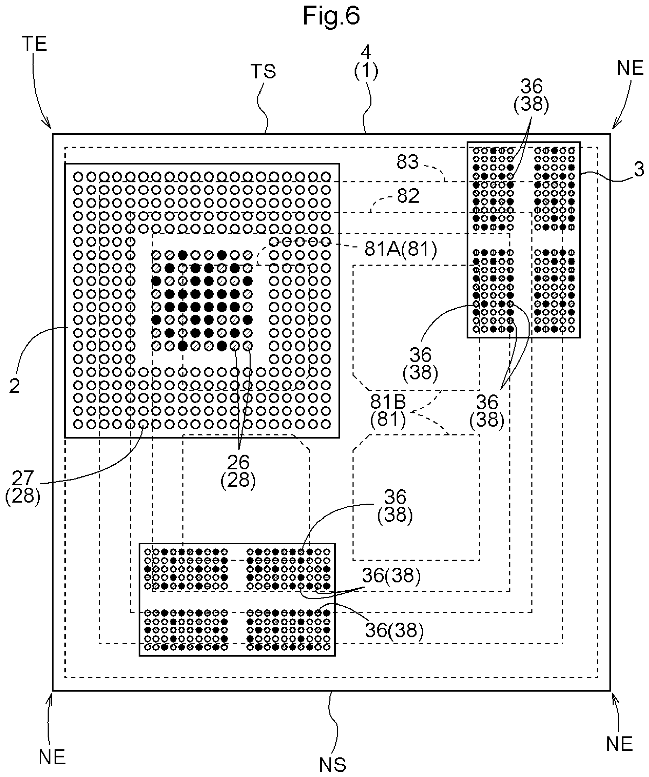

FIG. 6 illustrates a transparent plan view of the surfaces of the system LSI 2 and the memory 3 that face the module-substrate first surface 4a. The plan view of FIG. 6 is a view (the Z-direction view) when the semiconductor module 1 is viewed from the module-substrate first surface 4a side in the direction Z orthogonal to the module substrate 4. In order to make clear the positional relationship of the system LSI 2 and the memory 3 relative to the module substrate 4, the outside shape of the module substrate 4 is illustrated, and areas where the connection terminal groups 80 are located on the module-substrate second surface 4b are indicated by hidden lines. FIG. 7 is a schematic cross-sectional view of the semiconductor device 10.

As illustrated in FIG. 3 and FIG. 6, in the Z-direction view, the processor power terminals 26 (first power terminals), which are power terminals of the system LSI 2, overlap a first target terminal group 81A (a target terminal group) that is one of the plurality of first connection terminal groups 81. Further, as illustrated in FIG. 7, the connection terminals 8 that belong to the first target terminal group 81A that supply electric power to the system LSI 2 are connected to the processor power terminals 26. The processor power terminals 26 are connected to lands L on the module-substrate first surface 4a, and the lands L are connected via through holes TH (TH5) to the connection terminals 8 (the connection terminals 8 that belong to the first target terminal group 81A) of the module-substrate second surface 4b.

As illustrated in FIG. 3 and FIG. 6, in the Z-direction view, the memory power terminals 36 (second power terminals), which are power terminals of the memory 3, overlap the second connection terminal group 82. Although the memory power terminals 36 have three types as described above, namely, the first memory power terminals 31, the second memory power terminals 32, and the third memory power terminals 33, it is preferable that at least the first memory power terminals 31 overlap the second connection terminal group 82. It is further preferable that both the first memory power terminals 31 and the second memory power terminals 32 overlap the second connection terminal group 82. Naturally, all the types, that is, the first memory power terminals 31, the second memory power terminals 32, and the third memory power terminals 33 may overlap the second connection terminal group 82.

Further, as illustrated in FIG. 7, the connection terminals 8 in the second connection terminal group 82 that supply electric power to the memory 3 are connected to the memory power terminals 36. The memory power terminals 36 are connected to lands L on the module-substrate first surface 4a, and the lands L are connected via through holes TH (H3) to the connection terminals 8 (the connection terminals 8 that belong to the second connection terminal group 82) of the module-substrate second surface 4b. These connection terminals 8 are connected to land L formed on the main-substrate first surface 5a and are then connected to memory power lands L76 formed on the main-substrate second surface 5b via through holes TH (TH1) that connects the main-substrate first surface 5a and the main-substrate second surface 5b together. Ground lands L79 are also formed on the main-substrate second surface 5b, and the bypass capacitors 7 are mounted between the memory power lands L76 and the ground lands L79. The bypass capacitors 7 are capacitors to reduce harmonic noises, and, for example, ceramic capacitor of about 0.01 [µF] to 0.1 [µF] may be used therefor.

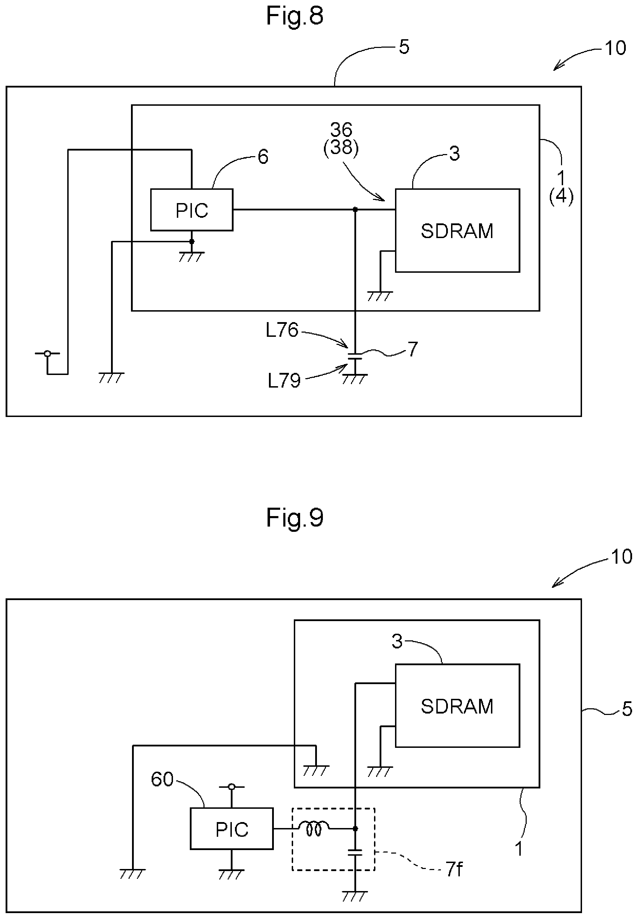

FIG. 8 is a schematic circuit block diagram illustrating one example of a relationship between the memory 3 and the bypass capacitor 7. As described above, the memory power terminal 36 of the memory 3 is supplied with electric power from the power supply IC 6 mounted on the module substrate 4. As described above, the memory power terminal 36 is connected to the memory power land L76 of the main substrate 5, and the bypass capacitor 7 is connected between the memory power terminal 36 and the ground land L79 of the main substrate 5. The ground of the module substrate 4 (the semiconductor module 1) and the ground of the main substrate 5 are electrically connected to each other so that the circuitry of the semiconductor module 1 and the circuitry of the main substrate 5 have common ground (reference potential). Thus, using the through holes TH to provide the wiring that connects the memory power terminals 36 to the main-substrate second surface 5b in the Z direction allows the bypass capacitors 7 to be mounted near the memory power terminals 36.

As illustrated in FIG. 4, the memory power terminals 36 are arranged dispersedly in directions along the module-substrate first surface 4a. Some of the memory power terminals 36 are arranged near the center (the center of gravity Q3) of the outside shape of the memory 3 in the Z-direction view. This may increase the distances from the memory power terminals 36 to the bypass capacitors 7, for example, when the bypass capacitors 7 are mounted on the module-substrate first surface 4a. However, as illustrated in FIG. 3, FIG. 7, among others, when the bypass capacitors 7 are mounted in the Z direction (in the direction orthogonal (in the direction normal) to the substrate surface of the module substrate 4) relative to the memory power terminals 36, it is possible to shorten the wiring from the memory power terminals 36 to the bypass capacitors 7, as compared to when the bypass capacitors 7 are mounted in directions (horizontal directions: for example, X-directions in FIG. 7) along the substrate surface of the module substrate 4.

Since the ground of the module substrate 4 (the semiconductor module 1) and the ground of the main substrate 5 are common as described above with reference to FIG. 8, the memory ground terminals 39 may be disconnected from the ground lands L79 of the main-substrate second surface 5b. However, since the memory power terminals 36 and the memory ground terminals 39 are power-supply-related pairs of the memory terminals 38 in the memory 3, the memory ground terminals 39 may be connected to the ground lands L79 via through holes TH (TH2, TH4) as illustrated in FIG. 7.

In the example described above with reference to FIG. 7, the memory power terminals 36 (second power terminals), which are power terminals of the memory 3, overlap the second connection terminal group 82 in the Z-direction view. However, as illustrated in FIG. 3 and FIG. 6, it is preferable that in the Z-direction view, the memory power terminals 36 (second power terminals) further overlap at least one of the plurality of first connection terminal groups 81 (a second target terminal group 81B) other than the first target terminal group 81A. Although illustration of a schematic cross-sectional view like FIG. 7 is omitted, the connection terminals 8 that belong to the second target terminal group 81B and that supply electric power to the memory 3 are connected to the memory power terminals 36. Similarly, although illustration of a schematic cross-sectional view like FIG. 7 is omitted, it is preferable that as illustrated in FIG. 3 and FIG. 6, in the Z-direction view, the memory power terminals 36 overlap the third connection terminal group 83, and the connection terminals 8 that belong to the third connection terminal group 83 and that supply electric power to the memory 3 are connected to the memory power terminals 36.

As described above, in many cases, ceramic capacitors are used for the bypass capacitors 7. Standard mass-produced surface mount capacitors (multi-layer ceramic capacitors) include a 2125-type (with an outside shape of 2 [mm] × 1.25 [mm]), a 1608-type (with an outside shape of 1.6 [mm] × 0.8 [mm]), and a 1005-type (with an outside shape of 1 [mm] × 0.5 [mm]). The 1608-type, the 1005-type, among others are the main stream (the largest market segment) of multi-layer ceramic capacitors having a capacitance of about 0.01 [µF] to 0.1 [µP], and thus are reduced in cost due to the effectiveness of mass production.

As illustrated in FIG. 3, the bypass capacitors 7 are mounted between the connection terminal groups 80 in the Z-direction view. For this reason, it is preferable that the distance (a terminal group gap) between the connection terminal groups 80 be greater than or equal to a value that allows multi-layer ceramic capacitors to be mounted therein. As illustrated in FIG. 3, in the Z-direction view, the bypass capacitors 7 are mounted not only between the first connection terminal groups 81 and the second connection terminal group 82, but also between the second connection terminal group 82 and the third connection terminal group 83. For this reason, it is preferable that the second group gap G12 and the third group gap G13 are set greater than or equal to sizes that allow the bypass capacitors 7 to be mounted therein.

As described above, the second group gap G12 and the third group gap G13 are set to values that are equal to or greater than 1 [mm] and less than 3 [mm] (about 2 [mm] when the thickness of the connection terminal 8 is less than 0.5 [mm]). Thus, it is possible to suitably mount 1608-type and 1005-type multi-layer ceramic capacitors between the first connection terminal groups 81 and the second connection terminal group 82, and between the second connection terminal group 82 and the third connection terminal group 83.

In the semiconductor module 1 that is of a BGA type, it is possible to draw wires W (refer to FIG. 7) on the main-substrate first surface 5a from the connection terminals 8 that are located near the outer edge, but it is difficult to draw the wires W on the main-substrate first surface 5a from locations near the center of gravity Q1. For this reason, the through holes TH are formed to the main-substrate second surface 5b from locations overlapping the connection terminals 8 in the Z-direction view (locations on the main-substrate first surface 5a corresponding to the lands L that are connected to the connection terminals 8, or in the vicinities (areas to adjacent connection terminals 8 (lands L)). That is, within an area where the connection terminals 8 of the semiconductor module 1 are arranged, openings of the through holes TH are arranged on the main-substrate second surface 5b in the same pattern as the connection terminals 8.

It is impossible to mount components on the through holes TH. Therefore, when the connection terminals 8 are arranged on the entire surface or when the second group gap G12 and the third group gap G13 are less than 1 [mm], it is impossible to mount the bypass capacitors 7 on the main-substrate second surface 5b. As in the present embodiment, when the second group gap G12 and the third group gap G13 are set greater than or equal to sizes that allow the bypass capacitors 7 (multi-layer ceramic capacitors) to be mounted therein, it is possible to suitably mount the bypass capacitors 7 on the main-substrate second surface 5b.

As illustrated in FIG. 1 to FIG. 3, FIG. 6, among others, according to the present embodiment, the center of gravity Q1 of the module substrate 4 and the center of gravity Q2 of the system LSI 2 do not coincide with each other in the Z-direction view, and the system LSI 2 is located toward one corner of the module substrate 4. The two memories 3 are arranged separately along vertical and horizontal directions in an L-shaped region of the module substrate 4 where the system LSI 2 is not located. Here, one of four corners of the module substrate 4 in the Z-direction view is referred to as a target corner TE, and the other three corners are referred to as non-symmetric corners NE. Further, sides that pass through the target corner TE in the Z-direction view are referred to as target sides TS, and sides that do not pass through the target corner TE are referred to as non-target sides NS. The system LSI 2 is located closer to the target corner TE than to any of the non-symmetric corners NE in the Z-direction view, and the memories 3 are located closer to the non-target sides NS that do not pass through the target corner TE in the Z-direction view. According to the present embodiment, the outside shapes of the memories 3 are rectangular, and the memories 3 are arranged such that the long sides thereof are along the non-target sides NS.

As described above, each of the first connection terminal groups 81 is distributed in a rectangular area in the Z-direction view, and the four first connection terminal groups 81 are arranged in two rows and two columns. The second connection terminal group 82 is arranged to surround the four first connection terminal groups 81. The third connection terminal group 83 is arranged to surround the second connection terminal group 82 and thus surrounds the four first connection terminal groups 81. On one side near the two target sides TS (near the target corner TE), a region between the first connection terminal group 81 (the first target terminal group 81A) and the second connection terminal group 82 and a region between the second connection terminal group 82 and the third connection terminal group 83 overlap the system LSI 2 in the Z-direction view. However, on the other side near the two non-target sides NS, the entire region between the first connection terminal group 81 (the second target terminal group 81B) and the second connection terminal group 82 and the entire region between the second connection terminal group 82 and the third connection terminal group 83 do not overlap the system LSI 2 in the Z-direction view. Thus, by arranging the memories 3 such that these regions overlap the memories 3 in the Z-direction view, it is possible to arrange the bypass capacitors 7 in regions on the main-substrate second surface 5b that overlap these regions in the Z-direction view. That is, in the semiconductor device 10, the bypass capacitors 7 for the memories 3 are mounted on the main-substrate second surface 5b at locations that overlap regions in the Z-direction view that are located between the second connection terminal group 82 and other connection terminal groups 80 adjacent to the second connection terminal group 82.

It is noted that since the system LSI 2 is located toward the target corner TE, the signal terminals (the processor signal terminals 27) of the system LSI 2 overlap the plurality of second connection terminal groups 82 on the target corner TE side, as shown in FIG. 6. Additionally, as illustrated in FIG. 7, the connection terminals 8 that belong to the second connection terminal group 82 and that correspond to the processor signal terminals 27 are connected to the processor signal terminals 27.

### [Other Embodiments]

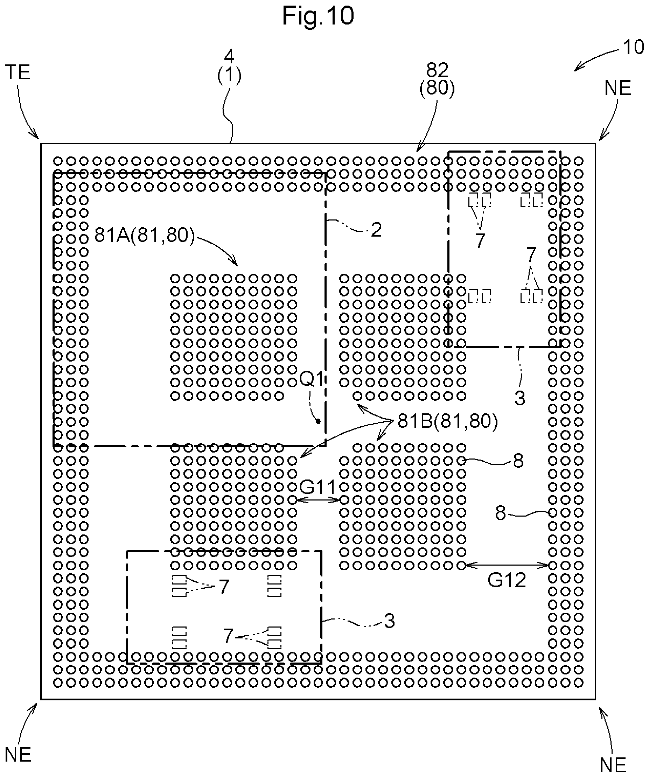

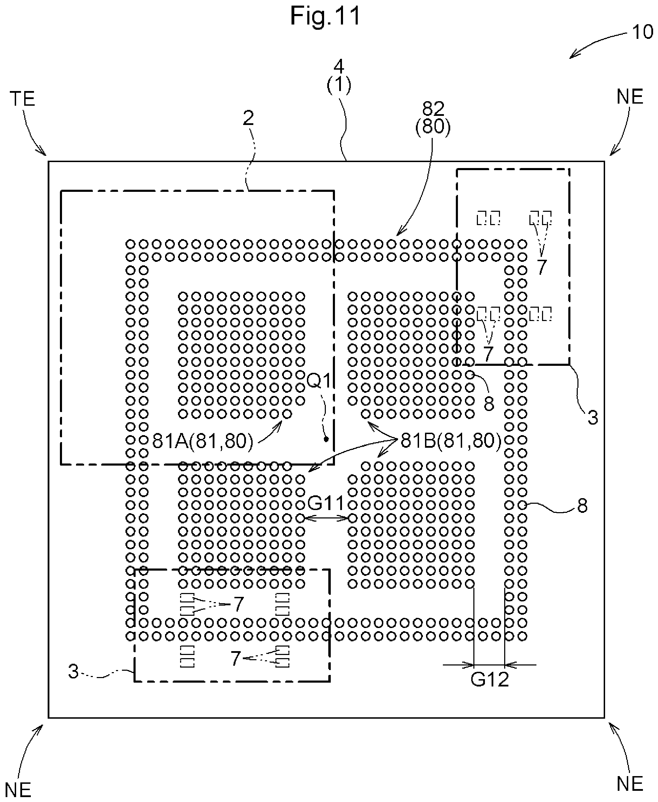

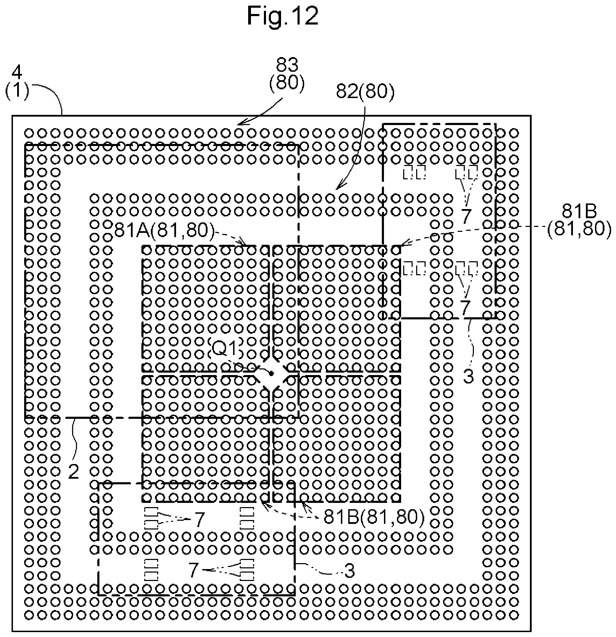

Other embodiments are described below. It is noted that, structures disclosed in any one of the embodiments described below may be used alone, or may be used in combination with structures disclosed in any other of the embodiments as long as there is no inconsistency.
(1) The example embodiment described above illustrates that the semiconductor module 1 is provided with the power supply IC 6 for generating electric power that is supplied to the memory 3. Alternatively, as illustrated in FIG. 9, the main substrate 5 may be provided with a power supply circuit 60 for generating electric power that is supplied to the memory 3, and the electric power may be supplied from the main substrate 5 to the semiconductor module 1. In this case, the passive components are not limited to the bypass capacitors 7, but include filters 7f, such as LC filters, mounted on the main-substrate second surface 5b, and the filters 7f may be connected to the memory power terminals 36 via the connection terminals 8 and the through holes TH in the main substrate 5. LC filters like that illustrated in FIG. 9 are also mass-produced as multi-layer LC filters having the same shape as multi-layer ceramic capacitors. Thus, as descried above, it is possible to mount the filters 7f on the main-substrate second surface 5b. The filters 7f are not limited to LC filters like that illustrated in FIG. 9 and may be RC filters having resistors instead of inductors. Such RC filters are also mass-produced as multi-layer RC filters having the same shape as multi-layer ceramic capacitors. Naturally, even when the main substrate 5 is provided with power supply circuit 60 for generating electric power that is supplied to the memory 3, as illustrated in FIG. 9, the bypass capacitors 7 may be mounted on the main-substrate second surface 5b.
(2) Although the example embodiment described above illustrates that the bypass capacitors 7 are connected to the memory 3, passive components that are configured to be connected to the system LSI 2, such as the bypass capacitors 7 and the filters 7f, may be mounted on the main-substrate second surface 5b as well.
(3) The example embodiment described above illustrates that the connection terminals 8 of the semiconductor module 1 have three types of connection terminal groups 80, namely, the first connection terminal groups 81, the second connection terminal group 82, and the third connection terminal group 83. Alternatively, as illustrated in FIG. 10 and FIG. 11, the connection terminals 8 may be structured to have: a plurality of (four) first connection terminal groups 81 that are arranged in a grid; and a second connection terminal group 82 that is arranged in a rectangular ring so as to surround the plurality of first connection terminal groups 81. Since the first gap G1 (the first pitch PI), the second gap G2 (the second pitch P2), the first group gap G11, and the second group gap G12 are the same as those in the embodiment described above, detailed description thereof is omitted. As illustrated in FIG. 10 and FIG. 11, also in these embodiments, the processor power terminals 26 of the system LSI 2 overlap the first target terminal group 81A in the Z-direction view, and the connection terminals 8 that belong to the first target terminal group 81A and that supply electric power to the system LSI2 are connected to the processor power terminals 26. Further, the memory power terminals 36 of the memory 3 overlap the second connection terminal group 82 in the Z-direction view, and the connection terminals 8 that belong to the second connection terminal group 82 and that supply electric power to the memory 3 are connected to the memory power terminals 36.
(4) The example embodiment described above illustrates that the first group gap G11 is wider than the first gap G1 and the second gap G2. Alternatively, the first group gap G11 may have the same value as the first gap G1 and the second gap G2. In other words, the first group gap G11 may be greater than or equal to the first gap G1 and the second gap G2. When the first group gap G11 has the same value as the first gap G1 and the second gap G2, the first connection terminal groups 81 can be regarded as a single collective connection terminal group 80, as illustrated in FIG. 12. However, as illustrated in FIG. 12, it can be considered that four first connection terminal groups 81 are virtually included. That is, even an embodiment like the one illustrated in FIG. 12 allows four first connection terminal groups 81 to be included and allows the first target terminal group 81A and the second target terminal group 81B to be selected therefrom. Thus, even a terminal arrangement like the one illustrated in FIG. 12 is capable of implementing the various embodiments described above. Although the example embodiment illustrated in FIG. 12 has the third connection terminal group 83, it is natural that the structure may be provided by the first connection terminal groups 81 and the second connection terminal group 82 only.
(5) Although the example described above illustrates that the semiconductor module 1 is provided with the system LSI 2 (a first semiconductor element) and the memory 3 (a second semiconductor element) as semiconductor elements, the semiconductor module 1 may be provided with, for example, a plurality of system LSIs 2 (processors). When the semiconductor module 1 is provided with a plurality of system LSIs 2 in that way, it is preferable that the outside shape of the first semiconductor element be greater than the outside shape of the second semiconductor element in the plan view.
(6) The example embodiment described above illustrates that both the system LSI 2 and the memory 3 are provided with BGA-type connection terminals (28, 38). Alternatively, the system LSI 2 and the memory 3 may be a quad flat J-leaded package (QFJ) or a small outline J-leaded package (SOJ) that have contact portions extending outward and down from the perimeter of an IC body and then bending inward to a lower portion (a surface that faces the module-substrate first surface 4a) of the IC body.
   This does not eliminate the possibility that the system LSI 2 and the memory 3 will be a small outline L-leaded package (SOP) or a quad flat gull wing leaded package (QFP) (that have L-shaped connection terminals extending laterally with respect to an IC body, not to a lower portion of the IC body.

### [Summary of the Embodiments]

Below is a brief summary of the semiconductor module (1) and the semiconductor device (10) described so far.

A semiconductor module (1) according to an aspect is a semiconductor module (1) in which a first semiconductor element (2) and a second semiconductor element (3) are mounted on a first surface (4a) of a rectangular module substrate (4) and in which a plurality of connection terminals (8) are provided on a second surface (4b) opposite the first surface (4a). The semiconductor module (1) is configured to be mounted on a main substrate (5) such that the second surface (4b) faces the main substrate (5). The plurality of connection terminals (8) provided on the second surface (4b) include a plurality of connection terminal groups (80) that are arranged regularly. The plurality of connection terminal groups (80) include a plurality of first connection terminal groups (81) in which adjacent ones of the connection terminals (80) are arranged with a first gap (G1) therebetween in a grid, and a second connection terminal group (82) in which adjacent ones of the connection terminals (8) are arranged with a second gap (G2) therebetween in a rectangular ring to surround the plurality of first connection terminal groups (81). The connection terminals (8) that are adjacent to each other between different ones of the first connection terminal groups (81) are arranged with a first group gap (G11) therebetween that is greater than or equal to the first gap (G1) and the second gap (G2). The connection terminals (8) that are adjacent to each other between each of the first connection terminal groups (81) and the second connection terminal group (82) are arranged with a second group gap (G12) therebetween that is wider than the first gap (G1) and the second gap (G2). In a plan view that is a view in a direction (Z) orthogonal to the module substrate (4), a first power terminal (26) that is a power terminal of the first semiconductor element (2) overlaps a target terminal group (81A) that is one of the plurality of first connection terminal groups (81). The connection terminal (8) that belongs to the target terminal group (81A) and that supplies electric power to the first semiconductor element (2) is connected to the first power terminal (26). In the plan view, a second power terminal (36) that is a power terminal of the second semiconductor element (3) overlaps the second connection terminal group (82). The connection terminal (8) that belongs to the second connection terminal group (82) and that supplies electric power to the second semiconductor element (3) is connected to the second power terminal (36).

This structure enables the connection terminal (8) that belongs to the target terminal group (81A) and that supplies electric power to the first semiconductor element (2) to be connected to the first power terminal (26) with a short wiring distance along the direction (Z) orthogonal to the module substrate (4). This structure also enables the connection terminal (8) that belongs to the second connection terminal group (82) and that supplies electric power to the second semiconductor element (3) to be connected to the second power terminal (36) with a short wiring distance along the direction (Z) orthogonal to the module substrate (4). It is noted here that a clearance of the second group gap (G12) is provided between the target terminal group (81A) (the first connection terminal group (81)) and the second connection terminal group (82). Thus, as described below, by using this clearance, it is possible to mount components on the main substrate (5) at locations close to the first power terminal (26) and the second power terminal (36). For example, in some cases, through holes (TH) may be formed in the main substrate (5) between a mounting surface (5a) on which the semiconductor module (1) is mounted and a surface (5b) opposite the mounting surface (5a) in order to electrically connect the opposite surface (5b) to the connection terminals (8). As a result, openings of the through holes (TH) may be formed on the opposite surface (5b) according to the arrangement of the connection terminals (8). It is impossible to mount components on the surface (5b) opposite the mounting surface (5a) at locations that overlap such openings in the plan view. However, since no connection terminals (8) are located in a region corresponding to the clearance of the second group gap (G12), such openings are not formed therein. Thus, it is possible to mount components in the region corresponding to the clearance of the second group gap (G12) in the plan view, on the surface (5b) of the main substrate (5) opposite the mounting surface (5a). That is, this structure enables passive components (7, 7f) to be arranged with a short wiring distance to the power terminals (26, 36) of the semiconductor elements (2, 3) mounted on the semiconductor module (1).

It is preferable here that the first semiconductor element (2) be a processor (2) and that the second semiconductor element (3) be a memory (3). In other words, a semiconductor module (1) is a semiconductor module (1) in which a processor (2) and a memory (3) are mounted on a first surface (4a) of a rectangular module substrate (4) and in which a plurality of connection terminals (8) are provided on a second surface (4b) opposite the first surface (4a). The semiconductor module (1) is configured to be mounted on a main substrate (5) such that the second surface (4b) faces the main substrate (5). The plurality of connection terminals (8) provided on the second surface (4b) include a plurality of connection terminal groups (80) that are arranged regularly. The plurality of connection terminal groups (80) include a plurality of first connection terminal groups (81) in which adjacent ones of the connection terminals (80) are arranged with a first gap (G1) therebetween in a grid, and a second connection terminal group (82) in which adjacent ones of the connection terminals (8) are arranged with a second gap (G2) therebetween in a rectangular ring so as to surround the plurality of first connection terminal groups (81). The connection terminals (8) that are adjacent to each other between different ones of the first connection terminal groups (81) are arranged with a first group gap (G11) therebetween that is greater than or equal to the first gap (G1) and the second gap (G2). The connection terminals (8) that are adjacent to each other between each of the first connection terminal groups (81) and the second connection terminal group (82) are arranged with a second group gap (G12) therebetween that is wider than the first gap (G1) and the second gap (G2). In a plan view that is a view in a direction (Z) orthogonal to the module substrate (4), first power terminals (26) that are power terminals of the processor (2) overlap a target terminal group (81A) that is one of the plurality of first connection terminal groups (81). The connection terminals (8) that belong to the target terminal group (81A) and that supply electric power to the processor (2) are connected to the first power terminals (26). In the plan view, second power terminals (36) that are power terminals of the memory (3) overlap the second connection terminal group (82). The connection terminals (8) that belong to the second connection terminal group (82) and that supply electric power to the memory (3) are connected to the second power terminals (36).

A processor (2) and a memory (3) often work in conjunction with each other, and there are many signal wires that are connected only between the processor (2) and the memory (3). This often allows a semiconductor module (1) provided with a processor (2) and a memory (3) to be provided with fewer connection terminals (8) than the total number of connection terminals (28) of the processor (2) and connection terminals (38) of the memory (3). Thus, mounting the semiconductor module (1) on the main substrate (5) improves wiring efficiently and mounting efficiency compared to when mounting the processor (2) and the memory (3) on the main substrate (5). In many cases, a processor (2) consumes a large amount of current and has many power terminals (26). A die that structures a processor (2) is located in the center of a package. Therefore, when connection terminals (28) of the processor (2) are of a BGA, the power terminals (26) are often located in the central area. Further, in memories (3), which grow in capacity, power terminals (36) are often arranged dispersedly in order to supply electric power evenly to internal memory cells of the memory (3). When passive components (7) are connected to power terminals (26) of a processor (2) and power terminals (36) of a memory (3), the wiring distance may increase, so that the effect of the passive components (7) may be limited. However, as described above, this structure enables passive components (7) to be mounted in the region corresponding to the clearance of the second group gap (G12) in the plan view, on the surface (5b) of the main substrate (5) opposite the mounting surface (5a). Thus, it is possible to connect passive components (7, 7f) to the power terminals (26) of the processor (2) and the power terminals (36) of the memory (3) with a short wiring distance along the direction orthogonal to the module substrate (4) and the main substrate (5).

Here, when the target terminal group (81A) is defined as a first target terminal group (81A), and at least one of the plurality of first connection terminal groups (81) other than the first target terminal group (81A) is defined as a second target terminal group (81B), it is preferable that the second power terminals (36) overlap the second target terminal group (82) in the plan view and that the connection terminals (8) that belong to the second target terminal group (81B) and that supply electric power to the memory (3) be connected to the second power terminals (36).

No connection terminals (8) are formed in the second group gap (G12) between the first connection terminal groups (81) and the second target terminal group (82). As described above, the power terminals (36) of the memory (3) overlap the second connection terminal group (82) in the plan view. When the power terminals (36) of the memory (3) further overlap the second target terminal group (81B) in the plan view that is one of the first connection terminals (81), the power terminals (8) of the memory (3) are located on both sides of a region that overlaps the clearance of the second group gap (G12) in the plan view. Thus, it is possible to efficiently mount passive components (7, 7f) in the region that overlaps the clearance of the second group gap (G12) in the plan view.

Further, it is preferable that the second power terminals (36) be arranged dispersedly in a direction along the first surface (4a) of the module-substrate (4), that a portion of the second power terminals (36) be connected to the second connection terminal group (82), and that another portion of the second power terminals (36) be connected to the second target terminal group (81B).

According to this structure, a portion of the second power terminals (36) and another portion of the second power terminals (36) are arranged, across the region of the second group gap (G12) where no connection terminals (8) are formed, from each other, and thus it is possible to arrange passive components (7, 7f) appropriately in the region that overlaps the clearance of the second group gap (G12).

Further, it is preferable that the plurality of connection terminals (8) include a third connection terminal group (83) in which adjacent ones of the connection terminals (8) are arranged with a third gap (G3) therebetween in a rectangular ring so as to surround the second connection terminal group (82), that the connection terminals (80) that are adjacent to each other between the second connection terminal group (82) and the third connection terminal group (83) be arranged with a third group gap (G13) therebetween that is wider than the first gap (G1), the second gap (G2), and the third gap (G3), that the second power terminals (36) overlap the third connection terminal group (83) in the plan view, and that the connection terminals (8) that belong to the third connection terminal group (83) and that supply electric power to the memory (3) be connected to the second power terminals (36).

This structure is provided with the third connection terminal group (83), thus allowing the semiconductor module (1) to be provided with a large number of connection terminals (8). Further, the third group gap (G13) is provided between the second connection terminal group (82) and the third connection terminal group (83). Thus, even when the number of connection terminals (8) increases, regions where passive components (7f) to be connected to the power terminals (26) of the processor (2) and the power terminals (36) of the memory (3) are mounted are provided.

Further, when the plurality of connection terminals (8) include a third connection terminal group (83) in which adjacent ones of the connection terminals (8) are arranged with a third gap (G3) therebetween in a rectangular ring so as to surround the second connection terminal group (82), it is preferable that the second power terminals (36) be arranged dispersedly in a direction along the first surface (4a) of the module substrate (4), that a portion of the second power terminals (36) be connected to the second connection terminal group (82), and that another portion of the second power terminals (36) be connected to the third connection terminal group (83).

According to this structure, a portion of the second power terminals (36) and another portion of the second power terminals (36) are arranged, across the region of the third group gap (G13) where no connection terminals (8) are formed, from each other, and thus it is possible to arrange passive components (7, 7f) appropriately in the region that overlaps the clearance of the third group gap (G13).

Further, it is preferable that second group gap (G12) be set greater than or equal to a size that allows at least one of a bypass capacitor (7) and a filter (7f) for the memory (3) to be mounted therein. Further, when the plurality of connection terminals (8) include the third connection terminal group (83), and the connection terminals (80) that are adjacent to each other between the second connection terminal group (82) and the third connection terminal group (83) are arranged with the third group gap (G13) therebetween, it is preferable that the third group gap (G13) be also set greater than or equal to a size that allows at least one of a bypass capacitor (7) and a filter (7f) for the memory (3) to be mounted therein.

This structure enables at least one of the bypass capacitor (7) and the filter (7f) of passive elements to be mounted appropriately in regions of the main substrate (5) that overlap, in the plan view, both the region between the first connection terminal groups (81) and the second connection terminal group (82) and the region between the second connection terminal group (82) and the third connection terminal group (83).

Here, it is preferable that in the plan view, signal terminals (27) of the processor (2) overlap the second connection terminal group (82) and that the connection terminals (8) that belong to the second connection terminal group (82) and that correspond to the signal terminals (27) of the processor (2) be connected to the signal terminals (8).

For example, when the connection terminals (28) of the processor (2) are of BGA type, the signal terminals (28) are often arranged closer to the perimeter than to the center by taking into account when signal wires are drawn. As described above, the processor (2) is arranged on the module substrate (4) such that the power terminals (26) overlap the target terminal group (81A) (the first connection terminal group (81)) in the plan view. Further, when the signal terminals (27) of the processor (2) overlap the second connection terminal group (82) in the plan view, the processor (2) is arranged on the module substrate (4) such that the center of gravity (Q1) of the outside shape of the module substrate (4) in the plan view and the center of gravity (Q2) of the outside shape of the processor (2) in the plan view do not overlap each other in the plan view. Thus, locations where other semiconductor elements such as the memory (3) are arranged are provided appropriately to structure the semiconductor module (1).

Further, it is preferable that the plurality of first connection terminal groups (81) and the second connection terminal group (82) be arranged to have four-fold rotational symmetry with a center of gravity (Q1) of an outside shape of the module substrate (4) in the plan view serving as a reference point of rotational symmetry.

Connection terminals (8) of a semiconductor module (1) are settable relatively flexibly in accordance with user specifications. Therefore, for example, reducing the number of connection terminals (8) appropriately may provide room for mounting passive components (7, 7f). However, a semiconductor module (1) provided with a plurality of semiconductor elements such as a processor (2) and a memory (3) has a relatively large area. For this reason, reducing the number of the connection terminals (8) may increase the difference in stress in directions along a substrate surface of the module substrate (4) when the semiconductor module (1) is mounted on the main substrate (5), and may reduce the mechanical strength accordingly. According to this structure, the plurality of first connection terminal groups (81) and the second connection terminal group (82) are arranged to have the second group gap (G12) therebetween and are also arranged to have four-fold rotational symmetry. Thus, it is possible to provide room for mounting passive components (7, 7f), while maintaining the mechanical strength when the semiconductor module (1) is mounted.

Further, when one of four corners of the module substrate (4) in the plan view is defined as a target corner (TE), and another three of the four corners are defined as non-symmetric corners (NE), it is preferable that the processor (2) be located closer to the target corner (TE) than to any of the non-symmetric corners (NE) in the plan view, that the memory (3) be located toward a side (NS) that does not pass through the target corner (TE) in the plan view, that each of the plurality of first connection terminal groups (81) be distributed in a rectangular area in the plan view, that the plurality of the first connection terminal groups include four first connection terminal groups (81) that are arranged in two rows and two columns, and that the second connection terminal group (82) surround the four first connection terminal groups (81).

According to this structure, the processor (2) is located toward one corner (the target corner (TE)) of the module substrate (4). Thus, it is possible to arrange one or a plurality of memories (3) along one or each of vertical and horizontal directions in an L-shaped region of the module substrate (4) where the processor (2) is not located. That is, it is possible to mount the processor (2) and the memory (3) on the module substrate (4) efficiently such that the first power terminals (26) of the processor (2) overlap the first target terminal group (81A) in the plan view and such that the second power terminals (36) of the memory (3) overlap the second terminal group (82) in the plan view.

A semiconductor device (10) according to an aspect is configured by mounting the semiconductor module (1) according to any aspect described above on a main-substrate first surface (5a) that is a surface on one side of the main substrate (5). The main substrate (5) is provided with through holes (TH) at locations overlapping, in the plan view, the connection terminals (8) that are connected to the second power terminals (36), and the through holes (TH) connect the main-substrate first surface (5a) and a main-substrate second surface (5b) that is opposite the main-substrate first surface (5a). At least one of a bypass capacitor (7) and a filter (7f) for the memory (3) is mounted on the main-substrate second surface (5b) at a location that overlaps a region in the plan view, and the region is located between the second connection terminal group (82) and another of the plurality of connection terminal groups (81, 83) that is adjacent to the second connection terminal group (81, 83).

As described above, this structure enables passive components (7) to be mounted in the region corresponding to the clearance of the second group gap (G12) in the plan view, on the surface (5b) of the main substrate (5) opposite the mounting surface (5a). Thus, it is possible to connect passive components (7) to the power terminals (26) of the processor (2) and the power terminals (36) of the memory (3) with a short wiring distance along the direction orthogonal to the module substrate (4) and the main substrate (5).

### Description of the Reference Numerals

1: semiconductor module
2: system LSI (processor, first semiconductor element)
3: memory (second semiconductor element)
4: module substrate
   4a: module-substrate first surface (first surface of module substrate)
   4b: module-substrate second surface (second surface of module substrate)
5: main substrate
   5a: main-substrate first surface
   5b: main-substrate second surface
7: bypass capacitor
7f: filter
8: connection terminal
10: semiconductor device
26: processor power terminal (power terminal of processor, first power terminal)
27: processor signal terminal (signal terminal of processor)
31: first memory power terminal (power terminal of memory, second power terminal)
32: second memory power terminal (power terminal of memory, second power terminal)
33: third memory power terminal (power terminal of memory, second power terminal)
36: memory power terminal (power terminal of memory, second power terminal)
37: memory signal terminal
39: ground terminal
80: connection terminal group
81: first connection terminal group
   81a: first target terminal group (target terminal group)
   81b: second target terminal group
82: second connection terminal group
83: third connection terminal group
G1 : first gap
G2: second gap
G3: third gap
G11: first group gap
G12: second group gap
G13: third group gap
NE: non-symmetric corner
NS: non-target side (side not passing through target corner)
Q1: center of gravity (center of gravity of outside shape of module substrate in plan view)
TE: target corner
TH: through hole
Z: direction orthogonal to module substrate

## Claims

1. A semiconductor module in which a first semiconductor element and a second semiconductor element are mounted on a first surface of a rectangular module substrate and in which a plurality of connection terminals are provided on a second surface opposite the first surface, the semiconductor module being configured to be mounted on a main substrate such that the second surface faces the main substrate, wherein
the plurality of connection terminals provided on the second surface include a plurality of connection terminal groups that are arranged regularly,
the plurality of connection terminal groups include a plurality of first connection terminal groups in which adjacent ones of the connection terminals are arranged with a first gap therebetween in a grid, and a second connection terminal group in which adjacent ones of the connection terminals are arranged with a second gap therebetween in a rectangular ring so as to surround the plurality of first connection terminal groups,
the connection terminals that are adjacent to each other between different ones of the first connection terminal groups are arranged with a first group gap therebetween that is greater than or equal to the first gap and the second gap,
the connection terminals that are adjacent to each other between each of the plurality of first connection terminal groups and the second connection terminal group are arranged with a second group gap therebetween that is wider than the first gap and the second gap,
in a plan view that is a view in a direction orthogonal to the module substrate, a first power terminal that is a power terminal of the first semiconductor element overlaps a target terminal group that is one of the plurality of first connection terminal groups,
the connection terminal that belongs to the target terminal group and that supplies electric power to the first semiconductor element is connected to the first power terminal,
in the plan view, a second power terminal that is a power terminal of the second semiconductor element overlaps the second connection terminal group, and
the connection terminal that belongs to the second connection terminal group and that supplies electric power to the second semiconductor element is connected to the second power terminal.

2. The semiconductor module according to claim 1, wherein
the first semiconductor element is a processor, and
the second semiconductor element is a memory.

3. A semiconductor module in which a processor and a memory are mounted on a first surface of a rectangular module substrate and in which a plurality of connection terminals are provided on a second surface opposite the first surface, the semiconductor module being configured to be mounted on a main substrate such that the second surface faces the main substrate, wherein
the plurality of connection terminals provided on the second surface include a plurality of connection terminal groups that are arranged regularly,
the plurality of connection terminal groups include a plurality of first connection terminal groups in which adjacent ones of the connection terminals are arranged with a first gap therebetween in a grid, and a second connection terminal group in which adjacent ones of the connection terminals are arranged with a second gap therebetween in a rectangular ring so as to surround the plurality of first connection terminal groups,
the connection terminals that are adjacent to each other between different ones of the first connection terminal groups are arranged with a first group gap therebetween that is greater than or equal to the first gap and the second gap,
the connection terminals that are adjacent to each other between each of the plurality of first connection terminal groups and the second connection terminal group are arranged with a second group gap therebetween that is wider than the first gap and the second gap,
in a plan view that is a view in a direction orthogonal to the module substrate, first power terminals that are power terminals of the processor overlap a target terminal group that is one of the plurality of first connection terminal groups,
the connection terminals that belong to the target terminal group and that supply electric power to the processor are connected to the first power terminals,
in the plan view, second power terminals that are power terminals of the memory overlap the second connection terminal group, and
the connection terminals that belong to the second connection terminal group and that supply electric power to the memory are connected to the second power terminals.

4. The semiconductor module according to claim 3, wherein
the target terminal group is defined as a first target terminal group,
at least one of the plurality of first connection terminal groups other than the first target terminal group is defined as a second target terminal group,
in the plan view, the second power terminals overlap the second target terminal group, and
the connection terminals that belong to the second target terminal group and that supply electric power to the memory are connected to the second power terminals.

5. The semiconductor module according to claim 4, wherein
the second power terminals are arranged dispersedly in a direction along the first surface of the module substrate,
a portion of the second power terminals is connected to the second connection terminal group, and
another portion of the second power terminals is connected to the second target terminal group.

6. The semiconductor module according to claim 4 or 5, wherein
the second group gap is set greater than or equal to a size that allows at least one of a bypass capacitor and a filter for the memory to be mounted therein.

7. The semiconductor module according to any one of claims 3 to 6, wherein
the plurality of connection terminals include a third connection terminal group in which adjacent ones of the connection terminals are arranged with a third gap therebetween in a rectangular ring so as to surround the second connection terminal group,
the connection terminals that are adjacent to each other between the second connection terminal group and the third connection terminal group are arranged with a third group gap therebetween that is wider than the second gap and the third gap,
in the plan view, the second power terminals overlap the third connection terminal group, and
the connection terminals that belong to the third connection terminal group and that supply electric power to the memory are connected to the second power terminals.

8. The semiconductor module according to claim 7, wherein
the second power terminals are arranged dispersedly in a direction along the first surface of the module substrate,
a portion of the second power terminals is connected to the second connection terminal group, and
another portion of the second power terminals is connected to the third connection terminal group.

9. The semiconductor module according to claim 7 or 8, wherein
the third group gap is set greater than or equal to a size that allows at least one of a bypass capacitor and a filter for the memory to be mounted therein.

10. The semiconductor module according to any one of claims 3 to 9, wherein
in the plan view, signal terminals of the processor overlap the second connection terminal group, and
the connection terminals that belong to the second connection terminal group and that correspond to the signal terminals of the processor are connected to the signal terminals.

11. The semiconductor module according to any one of claims 3 to 10, wherein
the plurality of first connection terminal groups and the second connection terminal group are arranged to have four-fold rotational symmetry with a center of gravity of an outside shape of the module substrate in the plan view serving as a reference point of rotational symmetry.

12. The semiconductor module according to any one of claims 3 to 11, wherein
one of four corners of the module substrate in the plan view is defined as a target corner,
another three of the four corners are defined as non-symmetric corners,
the processor is located closer to the target corner than to any of the non-symmetric corners in the plan view,
the memory is located toward a side that does not pass through the target corner in the plan view,
each of the plurality of first connection terminal groups is distributed in a rectangular area in the plan view,
the plurality of first connection terminal groups include four first connection terminal groups that are arranged in two rows and two columns, and
the second connection terminal group surrounds the four first connection terminal groups.

13. A semiconductor device in which the semiconductor module according to any one of claims 3 to 12 is mounted on a main-substrate first surface that is a surface on one side of the main substrate, wherein
the main substrate is provided with through holes at locations overlapping, in the plan view, the connection terminals that are connected to the second power terminals, the through holes connecting the main-substrate first surface and a main-substrate second surface that is opposite the main-substrate first surface, and
at least one of a bypass capacitor and a filter for the memory is mounted on the main-substrate second surface at a location that overlaps a region in the plan view, the region located between the second connection terminal group and another of the plurality of connection terminal groups that is adjacent to the second connection terminal group.
